## Europäisches Patentamt

## European Patent Office

## Office européen des brevets

(19)

(11) Veröffentlichungsnummer: **0 144 079**
**B1**

(12) **EUROPÄISCHE PATENTSCHRIFT**

(45) Veröffentlichungstag der Patentschrift: **13.06.90**

(21) Anmeldenummer: **84114470.2**

(22) Anmeldetag: **29.11.84**

(51) Int. Cl.⁵: **H 03 K 23/50, H 03 K 3/289**

(54) **Integrierbare Halbleiterschaltung für einen Frequenzteiler.**

(30) Priorität: **01.12.83 DE 3343573**

(43) Veröffentlichungstag der Anmeldung:
**12.06.85 Patentblatt 85/24**

(45) Bekanntmachung des Hinweises auf die
Patenterteilung:
**13.06.90 Patentblatt 90/24**

(84) Benannte Vertragsstaaten: ·
**AT DE FR GB IT NL**

(56) Entgegenhaltungen:
**US-A-4 168 540**

· **PATENTS ABSTRACTS OF JAPAN, Band 3, Nr.**
· **127 (E-146) 128r, 23. Oktober 1979, Seite 128 E**
**146; & JP - A - 54 105 453 (TOKYO SHIBAURA**
**DENKI K.K.) 18.08.1979**

**PATENTS ABSTRACTS OF JAPAN, Band 6, Nr.**
**128 (E-118) 1006r, 14. Juli 1982; & JP - A - 57 53**
**156 (TOKYO SHIBAURA DENKI K.K.) 30.03.1982**

(73) Patentinhaber: **Siemens Aktiengesellschaft**
**Wittelsbacherplatz 2**
**D-8000 München 2 (DE)**

(72) Erfinder: **Wilhelm, Wilhelm, Dr. Ing.**
**Geigenbergerstrasse 23**
**D-8000 München 71 (DE)**
Erfinder: **Incecik, Zafer, Dr.**
**Balanstrasse 69**
**D-8000 München 90 (DE)**

(56) References cited:
**PHILIPS TECHNICAL REVIEW, Band 38, Nr. 2,**
**1978/1979, Seiten 54-68; W.D. KASPERKOVITZ:**
**"Frequency-dividers for ultra-high frequencies"**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die vorliegende Erfindung befaßt sich mit einer integrierbaren Halbleiterschaltung für einen Frequenzteiler bzw, einen binären Zähler, der mittels nach dem Master-Slave-Prinzip arbeitenden bistabilen Kippstufen (Flip-Flopzellen) unter Verwendung von Transistoren vomselben Typ und Widerständen aufgebaut ist, bei der eine aus den zu verarbeitenden und einander gleichen Impulsen bestehende Signalfolge an den Eingang einer durch einen Differenzverstärker gebildeten Eingangsschaltung gelegt und der Differenzverstärker durch zwei Transistoren gegeben ist, deren Stromeingangselektroden miteinander sowie über eine Konstantstromquelle mit dem das Bezugspotentiel (Masse) führenden Versorgungsanschluß verbunden sind, während ihre Stromausgangselektroden über ein aus weiteren Transistoren sowie aus Widerständen gebildetes Netzwerk mit dem das Versorgungspotential führenden Versorgungsanschluß der Schaltung verbunden sind und bei der schließlich das Netzwerk derart ausgestaltet ist, daß es zusammen mit der Eingangsschaltung eine nach dem Master-Slave-Prinzip arbeitende bistabile Kippstufe ergibt, an deren beiden Ausgängen das von der Kippstufe gelieferte Ergebnis in Form von Impulsen abnehmbar ist.

Frequenzteiler bzw. asynchrone Impulszähler dieser Art sind z.B. in "Philips techn. Rdsch, 38, 47—62, 1979, Nr. 2" beschrieben. Sie werden bevorzugt unter Verwendung von Bipolartransistoren, insbesondere vom npn-Typ, hergestellt. Es besteht aber auch die Möglichkeit, sie mit Hilfe von Feldeffekttransistoren, insbesondere mit selbstsperrenden MOS-FET's, aufzubauen. Im Falle der Verwendung von Bipolartransistoren bedeutet der Begriff "Stromeingangselektrode" den Emitteranschluß, der Begriff "Stromausgangselektrode" den Kollektoranschluß, während die Steuerelektrode durch den Basisanschluß des einzelnen Transistors gegeben ist. Wird die Schaltung mittels Feldeffekttransistoren aufgebaut, so bedeutet der Drainanschluß die Stromausgangselektrode, der Sourceanschluß die Stromeingangselektrode und das Gate die Steuerelektrode.

Zu Frequenzteilerschaltungen bzw. Digitalzählerschaltungen der eingangs definierten Art läßt sich nun feststellen, daß die Anforderungen an das dynamische Verhalten bei einer aus mehreren Teiler- bzw. Zählstufen aufgebauten Schaltung hinsichtlich der einzelnen Stufen unterschiedlich sind. Während die erste Stufe die Eingangsfrequenz, d.h. also die höchste Frequenz, zu verarbeiten hat, erhält die zweite Stufe nur die halbe Frequenz und allgemein die p-te Stufe nur den $(2^{p-1})$-ten Teil der Eingangsfrequenz.

Es besteht nun die möglichkeit, gleichzeitig mit der Verringerung der dynamischen Anforderungen längs der Kette von Teiler- bzw. Zählstufen auch die Stromaufteilung auf die einzelnen Stufen zu staffeln, um auf diese Weise eine Verminderung der Gesamtverlustleistung der den Teiler bzw. die Zählerschaltung bildenden Flip-Flopkette zu erreichen. Beispielsweise kann man die einzelnen Stufen der Kette so dimensionieren, daß —ausgehend von der Eingangsstufe—beim Fortschreiten von Stufe zu Stufe entsprechend dem durch die bei der Herstellung angewandte Technologie gegebenen Verlustleistungs-Laufzeitprodukt jeweils eine Halbierung der für den Betrieb der betreffenden Stufe im Vergleich zur jeweils vorangehenden Stufe angestrebt ist.

Aus Patent Abstracts of Japan, Band 3, Nr, 127 (E-146), 23.10.79, Seite 128 E 146 sowie der JP—A—54 105 453 ist eine mehrstufige, insbesondere eine dreistufige Frequenzteilerschaltung bekannt, bei der jede Teilerstufe als bistabile Kippstufe nach dem Master-Slave-Prinzip unter Verwendung von Transistoren vom selben Typ und Widerständen aufgebaut ist, bei der die Eingangsschaltung durch Differenzverstärker gebildet wird, die aus jeweils zwei Transistoren bestehen, deren Emitteranschlüsse miteinander sowie über je eine Stromquelle mit dem Bezugspotential verbunden sind und deren Kollektoren mit den Eingängen (Emitteranschlüssen) der vorgeschalteten Teilerstufe verbunden sind. Die Eingänge der folgenden Teilerstufen liegen bei solchen bekannten Schaltungen über je einen, zur vorherigen Teilerstufe gehörenden Lastwiderstand unter Vermittlung einer jeweiligen, über je einen als Bias-Treiber eingesetzten Transistor angesteuerten, die Stromverteilung steuernde Transistorstufe an den das nicht invertierte Signal bereitstellenden Q-Ausgängen der vorherigen Teilerstufe, und die Lastwiderstände der letzten Teilerstufe sind mit dem Versorgungspotential verbunden.

Aufgabe der vorliegenden Erfindung ist es, eine mehrstufige Teilerschaltung bereitzustellen, die bei gegebener Versorgungsspannung eine möglichst große Anzahl an Teilerstufen zuläßt und sich trotzdem durch eine möglichst geringe Leistungsaufnahme auszeichnet.

Diese Aufgabe wird erfindungsgemäß durch eine Halbleiterschaltung nach dem Patentanspruch 1 gelöst.

Besonders günstige Ausgestaltungsformen sind Gegenstand von Unteransprüchen.

Erfindungsgemäß ist eine gattungsgemäße Halbleiterschaltung derart ausgestaltet, daß zwischen dem Versorgungsanschluß für das Versorgungspotential und dem genannten Netzwerk eine erste Verbindung unter Vermittlung eines dem genannten Netzwerk schaltungsmäßig entsprechenden zweiten Netzwerks und eine zweite Verbindung unter Vermittlung eines bezüglich des Spannungsabfalls an das zweite Netzwerk angeglichenen weiteren Schaltungsteils gegeben ist, daß zur Realisierung der ersten Verbindung die zum Slaveteil der bistabilen Kippstufe gehörenden beiden Ausgänge des ersten Netzwerks über den jeweils zugehörigen Lastwiderstand im ersten Netzwerk an je einen der beiden Eingänge des zweiten Netzwerks, welche den beiden durch die Eingangsschaltung beaufschlagten Eingängen des ersten Netzswerks entsprechen, gelegt, während die Lastwiderstände des zweiten Netzwerks mit dem Anschluß für das Versorgungspotential verbunden sind, und daß schließlich zur Realisierung der zweiten Verbindung zwischen dem ersten Netzwerk und dem Anschluß für das Versorgungspotential die zum Masterteil der bistabilen Kippstufe gehörenden beiden Ausgänge des ersten Netzwerks über den an das zweite Netzwerk hinsichtlich des Spannungsabfalls angeglichenen weiteren Schaltungsteil an den Versorgungsanschluß für das Versorgungspotential gelegt sind.

Bei einer der Erfindung entsprechenden Schaltung für einen Frequenzteiler bzw. Zähler sind somit—im Gegensatz zu den üblichen Schaltungen dieser Art—die die einzelnen Stufen darstellenden Flip-Flopzellen der Frequenzteiler-bzw. Zählerkette nicht in gleicher Weise mit Strom versorgt. Vielmehr sind bei einer der Erfindung entsprechenden Schaltung die einzelnen Teilerstufen, ähnlich den "series-gated CML-Gates" in wenigstens zwei Potentialebenen in Serie geschaltet. Das hat folgende Vorteile:

a) Der Strom für die zweite und ggf. eine weitere Stufe (bei 5 V Versorgungsspannung) wird aus der ersten Stufe und nicht der Versorgung entnommen, was erfahrungsgemäß zu einer Halbierung der Gesamtverlustleistung führt.

b) Für die zweite und dritte Stufe wird kein Pegelverschieber (=Pegelshifter) benötigt, was die Halbierung der aufzuwendenden Pegelshifterleistung bedeutet, da dieser nur in der ersten Stufe gebraucht wird.

c) Wegen des Wagfalls von zwei Pegelshifterpaaren ist eine merkliche Veringerung des Aufwands an Bauelementen, also an Transistoren und Widerständen, gegeben.

Die Erfindung wird nun anhand der Figuren näher beschrieben.

In Fig. 1 ist das Schaltbild einer Teilerstufe dargestellt, die dem Stand der Technik und der eingangs gegebenen Definition entspricht.

In Fig. 2 die in Fig. 1 dargestellte Schaltung dahingehend abgeändert, indem nur eine einzige Eingangschaltung verwendet ist.

In Fig. 3 ist die übliche Ausgestaltung eines zweistufigen Frequenzteilers dargestellt, der mittels der in Fig. 2 dargestellten Ausgestaltung der verwendeten Master-Slave-Flip-Flopzellen aufgebaut ist.

In Fig. 4 ist das Prinzipschaltbild für die vorliegende Erfindung für einen zweistufigen Teiler und in Fig. 5 für einen dreistufigen Teiler im Blockschaltbild gezeigt.

Fig. 6 und Fig. 7 sind Beispiele für eine der Erfindung entsprechende Ausgestaltung eines Frequenzteilers im Detail dargestellt.

Dabei ist zu bemerken, daß die in den Zeichnungen dargestellten Transistoren ausschließlich bipolare npn-Transistoren sind. Eine Ausgestaltung unter Verwendung anderer Transistortypen, z.B. von pnp-Transistoren oder von MOS-Transistoren ist im Prinzip ebenfalls möglich.

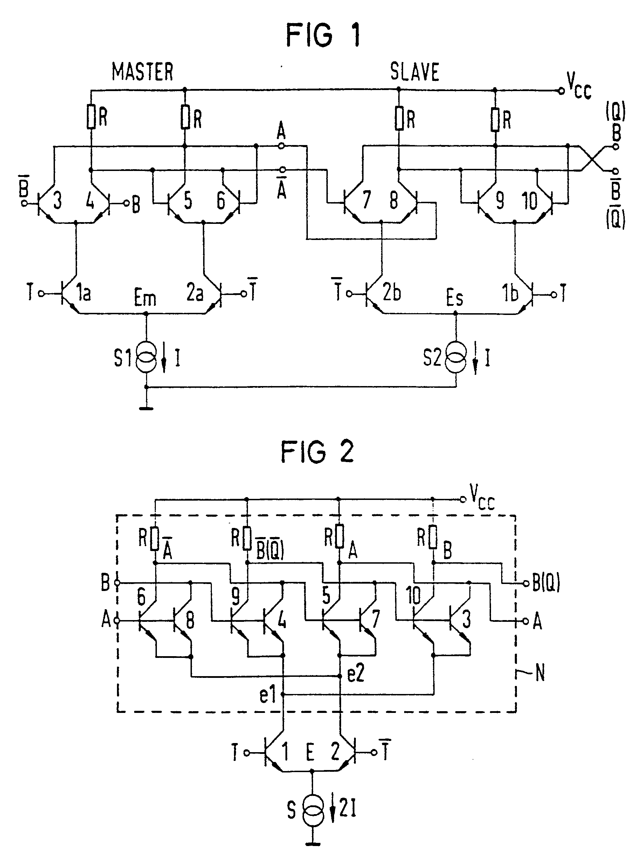

Das in Fig. 1 dargestellte Schaltbild eines in CML-Technik (=Current mode logic) realisierten einstufigen Frequenzteilers gemäß der eingangs gegebenen Definition und gemäß dem Stand der Technik (also eines üblichen Master-Slave-RS-Flip-Flops) enthält zwei durch zueinander invertierte Impulsfolgen T, $\overline{T}$ gesteuerte Eingangsdifferenzverstärker Em und Es, von denen der Eingangsteil Em dem Master-Flip-Flopteil und der Eingangsteil Es dem Slave-Flip-Flopteil angehört. Der Differenzverstärker Em besteht aus den beiden Transistoren 1a und 2a, deren Emitter über eine gemeinsame erste Konstantstromquelle S1 mit dem Bezugspotential $V_{ss}$, also dem Massenanschluß der Schaltung, verbunden und dadurch mit einem Strom I versorgt sind. Der den dem Slaveteil zugeordneten Eingangsteil Es besteht aus den beiden Transistoren 1b und 2b, deren Emitter über eine der Stromquelle S1 gleiche zweite Konstantstromquelle S2 am Bezugspotential liegen. Dabei wird der Transistor 1a das ersten Eingangsteils Em und der Transistor 1b des zweiten Eingangsteils Es vom Takt T und der andere Transistor 2a bzw. 2b der beiden Eingangsteile em und Es durch den zu T invertierten Takt $\overline{T}$ gesteuert. Die beiden Konstantstromquellen S1 und S2 sind in üblicher Weise, z.B. als Ausgangstransistoren eines Stromspiegels ausgestaltet. Dabei können die beiden durch je einen Transistor vom Typ der in der Schaltung verwendeten Transistoren gegebenen Stromquellen S1 und S2 gemeinsam durch einen als Diode geschalteten Stromspiegeleingang gesteuert sein.

Die die beiden Eingangsteile Em und Es steuernden beiden Taktfolgen T und $\overline{T}$ stellen jeweils die zu teilende Frequenz (oder die zu zählenden Impulse) der, die durch einen Frequenzgenerator, z.B. einen Rechteckimpulsgenerator mit einem nichtinvertierenden Ausgang und einem invertierenden Ausgang zur Verfügung gestellt sein kann.

Die in Fig. 1 dargestellte Schaltung für ein CML-Master-Slave-Flip-Flopzelle zeigt somit die einander gleichen Eingangsteile Em und Es, von denen Em für den Masterteil und Es für den Slaveteil zuständig ist.

Hierzu liegtim Masterteil der Kollektor des vom Takt T gesteuerten Transistors 1a das als Stromschalter wirkenden Eingangsteils Em am Emitter zweier weiterer—ebenfalls einen Differenzverstärker bildender—Transistoren 3 und 4. Der vom invertierten Takt $\overline{T}$ gesteuerte zweite Transistor 2a des Eingangsteils Em liegt mit seinem Kollektor ebenfalls am Emitter zweier weiterer Transistoren 5 und 6, die ebenfalls einen Differenzverstärker bilden. Dabei sind die Transistoren der beiden vom Eingangsteil Em stromgesteuerten weiteren Differenzverstärker über ihre Kollektoren derart zusammengefaßt, daß jeder Transistor des einen der beiden Differenzverstärker mit je einem Transistor des anderen Differenzverstärkers über seinen Kollektor zu einen Paar zusammengefaßt ist und dabei die Kollektoren des jeweiligen Transistorpaars über einen gemeinsamen Lastwiderstand R mit der Klemme für das Versorgungspotentiel $V_{cc}$ verbunden sind. Im gezeichneten Beispielsfalls liegt somit der Kollektor des Transistors und des Transistors 5 über gemeinsamen ersten Widerstand R und der Kollektor der Transistoren 4 und 6 über einen gemeinsamen zweiten Widerstand R an $V_{cc}$. Außerdem ist der Basisanschluß der beiden den einen der beiden zuletzt genannten Differenzverstärker bildenden Transistoren (im gezeichneten Beispielsfall des durch den invertierten Takt $\overline{T}$ stromgesteuerten Differenzverstärkers aus den Transistoren 5 und 6) jeweils mit dem Kollektor des anderen Transistors dieses Differenzverstärkers verbunden, so daß diese beiden Transistoren (also die Transistoren 5 und 6) zusammen ein RS-Flip-Flop bilden. Die beiden Transistoren des anderen der beiden zuletzt genannten Differenzverstärker (im gezeichneten Beispielsfall die Transistoren 3 und 4 des durch den nichtinvertierten Takt T stromgesteuerten Differenzverstärkers) sind hingegen durch die beiden Ausgängs B, $\overline{B}$ des Slave-Flip-Flops an ihrem Basisanschluß derart beaufschlagt, daß der eine Transistor (im gezeichneten Fall der Transistor 3) durch den invertierenden Ausgang $\overline{B}$ und der andere Transistor (in Fig. 1 der Transistor 4) an seiner Basis durch den nichtinvertierten Ausgang B des Slave-Flip-Flops gesteuert ist. Andererseits bilden die Knoten an den beiden Lastwiderständen R des Masterteils je einen Ausgang des Master-flip-Flops, wobei der am einen Transistor jedes der beiden Differenzverstärker 3, 4 bzw. 5, 6 liegende Knoten jeweils zueinander invertierte Ausgänge bilden. In Fig. 1 bilden somit die Kollektoren der Transistoren 3 und 5 den Ausgang A und die Kollektoren der Kollektoren 4 und 6 den Ausgang $\overline{A}$ des Master-Flip-Flops.

In gleicher Weise ist der Slaveteil der Teilerstufe im Prinzip ausgestaltet. Hier ist jedoch der durch den nichtinvertierten Takt T gesteuerte Transistor 1b der zugehörigen Eingangsschaltung Es zur Beaufschlagung des als RS-Flip-Flop weiter gestalteten Differenzverstärkers vorgesehen, der wie aus Fig. 1 ersichtlich, aus den Transistoren 9 und 10 besteht. Hierzu ist durch Kreuzkopplung eine leitende Verbindung zwischen der Basis des Transistors 9 mit dem Kollektor des Transistors 10 sowie eine leitende Verbindung zwischen der Basis des Transistors 10 mit dem Kollektor des Transistors 9 geschaffen. Außerdem liegt der Kollektor des Transistors 9 einerseits über einen Lastwiderstand R am Versorgungspotential $V_{cc}$ und anderseits am Kollektor das Transistors 7, der zu dem vom invertierten Takt $\overline{T}$ über den Transistor 2b der Eingangsschaltung Es stronggesteuerten Differenzverstärker aus den emittergekoppelten Transistoren 7 und 8 gehört. Dabei liegt außerdem der Kollektor des Transistors 8 am Kollektor des Transistors 10 und außerdem über einen weiteren Lastwiderstand R am Versorgungspotential $V_{cc}$. Er bildet außerdem den invertierten Ausgang $\overline{B}$ des Slave-Flip-Flops. Der nichtinvertierte Ausgang des Slave-Flip-Flops ist durch den Kollektor der Transistoren 7 und 9 gegeben, der über einen weiteren Lastwiderstand R im Slaveteil am Versorgungspotential liegt. Die Basisanschlüsse der beiden Transistoren 7 und 8 des vom

invertierten Takt $\overline{T}$ im Slaveteil stromgesteuerten Differenzverstärkers 7, 8 bilden den von den beiden Ausgängen A und $\overline{A}$ des Masterteils gesteuerten Eingang des Slaveteils. Hierzu liegt die Basis das Transistors 7 am invertierenden Ausgang $\overline{A}$, also am Kollektor der Transistoren 4 und 6 im Masterteil. Die Basis des Transistors 8 ist mit dem nichtinvertierenden Ausgang A des Masterteils, also mit dem Kollektor der Transistoren 3 und 5 verbunden. Umgekehrt liegt zur Realisierung einer Rückkopplung des Slaveteils auf den Masterteil der Kollektor der Transistoren 8 und 10, also der Ausgang B, an der Basis des Transistors 4 sowie der Kollektor der Transistoren 7 und 9, also der Ausgang $\overline{B}$ an der Basis des Transistors 5 im Masterteil.

Man kann nun, wie aus Fig. 2 ersichtlich, die beiden Eingangsteile Em und Es zu einem einzigen Eingangsteil E zusammenfassen, der dann von der ihm zugehörigen Konstantstromquelle S mit dem doppelten Strom 2I im Vergleich zu dem von jeder der beiden Stromquellen S1 und S2 der Schaltung gemäß Fig. 1 gelieferten Strom I beaufschlagt wird, vorausgesetzt, daß die Lastwiderstände R und die Transistoren 3 bis 10 der Schaltung gemäß Fig. 1 unverändert übernommen werden und die Transistoren 1 und 2 des Eingangsteils E mit den Transistoren 1a, 1b, 2a, 2b der Eingangsteile Em und Es übereinstimmen. Es ergibt sich dann automatisch die aus Fig. 2 ersichtliche Anschaltung der Transistoren 4, 6, 8 und 9 an den vom Takt T gesteuerten Transistor 1 (der den beiden Transistoren 1a und 1b gemäß Fig. 1 entspricht) sowie die Anschaltung der Transistoren 3, 5, 7, 10 an den Transistor 2 im Eingangsteil E.

Man erkennt nun, daß die Gesamtheit der Transistoren 3—10 und die vier Lastwiderstände R eine Art Netzwerk N bilden, das über die Lastwiderstände R an das Versorgungspotential $V_{cc}$ und über seinen ersten Eingang e1 (der durch die Emitter der Transistoren 4, 9, 3 und 10 gegeben ist) an den Kollektor des durch T gesteuerten Transistors 1 und über seinen zweiten Eingang e2 (der durch die Emitter der Transistoren 5, 6, 7 und 8 gegeben ist) an den Kollektor des durch den invertierten Takt $\overline{T}$ gesteuerten Transistors 2 des den Eingangsteil E bildenden Differenzverstärkers gelegt ist. Auf diese Sachlage geht die eingangs gegebene Definition zurück. Jede dieser Master-Slave-Flip-Flop-zellen entsprechend Fig. 1 bzw. Fig. 2 stellt einen 1:2-Teiler oder auch eine binäre Zählerstufe dar.

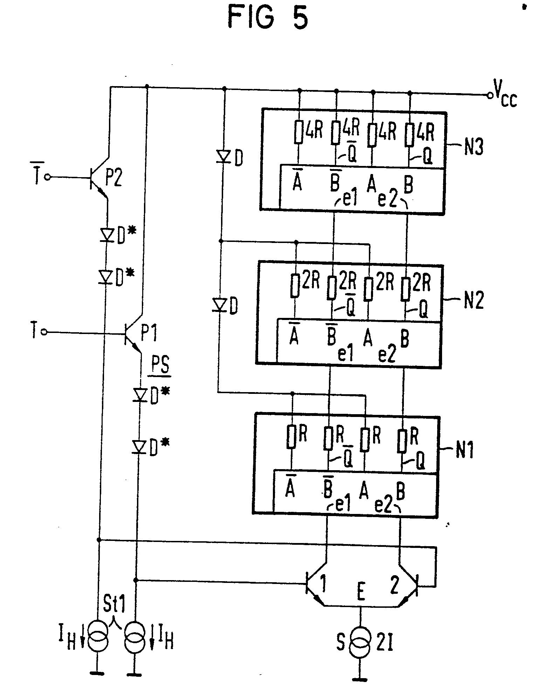

Will man nun unter Verwendung der in Fig. 2 dargestellten Master-Slave-Flip-Flopzelle in der üblichen Weise einen zweistufigen Teiler, also einen 1:4-Teiler, herstellen, so legt man die beiden Ausgänge B bzw. $\overline{B}$ des Slaveteils einer ersten Teilerstufe (die in üblicher Weise mit Q bzw. $\overline{Q}$ bezeichnet werden) an den Eingang einer zweiten Teilerstufe, der durch die Basisanschlüsse der beiden Transistoren 1 und 2 in Eingangsteil der zweiten Stufe gegeben ist. Dabei benötigt man jedoch eine zwischen geschaltete Pegelverschiebungsanlage, wie sie in Fig. 5 dargestellt ist.

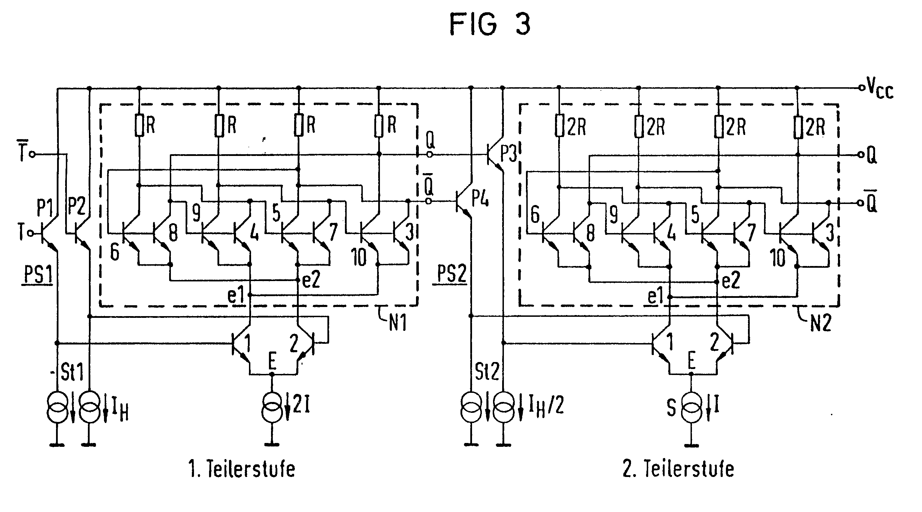

Wie aus Fig. 3 ersichtlich liegt dann der Q-Ausgang des ersten Master-Slave-Flip-Flops, dessen Teilernetzwerk mit N1 bezeichnet ist, an der Basis eines Pegelverschiebungstransistors P3, der in Kollektorschaltung betrieben und daher mit seinem Kollektor an die Klemme für das Versorgungspotential $V_{cc}$ gelegt ist. (Der Q-(oder B)-Ausgang ist, wie bereits festgestellt, durch den Kollektor der der Transistoren 8 und 10 im Slave-Flip-Flop gegeben.) Der $\bar{C}$-Ausgang (oder $\bar{B}$-Ausgang) des ersten Master-Slave-Flip-Flops (der durch den Kollektor der Transistoren 7 und 9 im Slaveteil gegeben ist) liegt ebenfalls an der Basis eines zweiten Pegelverschiebertransistors P4, dessen Kollektor ebenfalls an $V_{cc}$ liegt. Beide Pegelverschiebertransistoren P3 und P4 liegen am Ausgang je einer Konstantstromquelle St2, deren Fußpunkt durch das Bezugspotential (Masse) gegeben ist. Beide Pegelverschiebertransistoren P3 und P4 und die beiden zugehörigen Stromquellen St2 bilden die die Beaufschlagung des Eingangsteils E der zweiten Frequenzteilerstufe vermittelnde Pegelverschiebungsanlage PS2, wobei der vom Q-Ausgang der ersten Stufe gesteuerte Transistor P3 mit seinem Emitter zur Steuerung des Transistors 1 (er liefert also den Takt T für die zweite Stufe) und der vom $\bar{Q}$-Ausgang gesteuerte Transistor P4 mit seinem Emitter zur Steuerung des Transistors 2 (er liefert also den Takt $\bar{T}$) der Eingangsschaltung E der zweiten Teilerstufe vorgesehen ist. Das Netzwerk der zweiten Teilerstufe ist mit Rücksicht auf die nun folgenden und der Beschreibung der Erfindung dienenden Figuren mit N2, das Netzwerk der ersten Teilerstufe mit N1 bezeichnet. Es empfiehlt sich nämlich im Interesse der Verminderung der Verlustleistung die Lastwiderstände in den aufeinanderfolgenden Stufen binär zu wichten, so daß im gezeichneten Beispielsfall das Netzwerk N2 der zweiten Stufe mit Lastwiderständen ausgestattet ist, die den doppelten Widerstandswert der Lastwiderstände der ersten Teilerstufe haben. Sie sind demgemäß mit "2R" bezeichnet. Man kann aber auch, falls dies aus irgend einem Grund erwünscht sein sollte, von einer Wichtung der Lastwiderstände in den aufeinanderfolgenden Teilerstufen absehen.

Die an die Basis der Transistoren 1 und 2 des Eingangs E der ersten Teilerstufe vorgesehen Impulse werden im allgemeinen ebenfalls über eine solche Pegelverschiebungsschaltung PS1 der ersten Stufe zugeführt. Die dort verwendeten Transistoren P1 und P2 sind ebenfalls mit ihrem Emitter über je eine Stromquelle St1 mit der Klemme für das Bezugspotential (Masse) und mit ihrem Kollektor unmittelbar mit der Klemme für das Versorgungspotential $V_{cc}$ verbunden, während der von der zu verarbeitenden Taktfolge T gesteuerte Transistor P1 mit seinem Emitter an der Basis des Transistors 1 und der von der invertierten Taktfolge $\bar{T}$ gesteuerte Pegelverschiebertransistor P2 mit seinem Emitter an der Basis des Transistors 2 der Eingangsschaltung E der ersten Teilerstufe liegt. Festzustellen ist dabei, daß die zur Beaufschlagung des der ersten Teilerstufe zugeordneten Pegelverschiebers PS1 vorgesehenen beiden Stromquellen einen Strom $I_H$ liefern, der in beiden Fällen gleich ist. Die zur Beaufschlagung des der zweiten Teilerstufe PS2 zugeordneten beiden Stromquellen St2 liefern demgegenüber nur den Strom $I_H/2$ an den Transistor P3 bzw. P4. Wäre noch eine dritte Teilerstufe vorgesehen, so wäre deren Eingang in gleicher Weise von den Ausgängen Q und $\bar{Q}$ der zweiten Teilerstufe gesteuert, wie der Eingang der zweiten Stufe durch die beiden Ausgänge Q und $\bar{Q}$ der ersten Stufe gemäß Fig. 3 beaufschlagt ist. Die zugehörigen Stromquellen des dann die beiden Ausgänge der zweiten Stufe mit dem Eingang E der dritten Stufe verbindenen weiteren Pegelverschiebers führen dann den Strom $I_H/4$. Diese abnehmende Wichtung der Stromspeisung der Pegelverschiebungstransistoren führt einerseits zu einer Verminderung der Verlustleistung ebenso wie die Wichtung der Lastwiderstände in den Netzwerken der aufeinanderfolgenden Teilerstufen. Sie führt aber auch zu einer Verlangsamung der einzelnen Stufen im Vergleich zu der jeweils vorangehenden Stufe, was aber in anbetracht der jeweils von der betreffenden Stufe zu verarbeitenden Frequenz nicht störend ist. Die vier Lastwiderstände einer dritten Teilerstufe hätten unter den gebrachten Gesichtspunkten jeweils den Widerstandswert 4R.

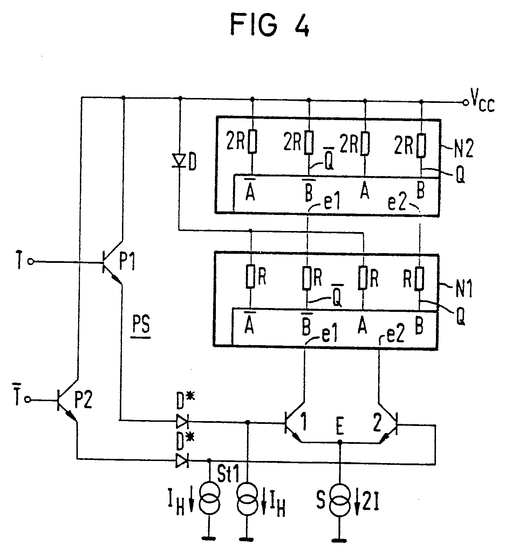

Bei einer der Erfindung entsprechenden Ausgestaltung eines Frequenzteilers hat man, wie aus Fig. 4 bzw. Fig. 5 ersichtlich, nur einen der Eingangsstufe zugeordneten Pegelverschieber, während die zweite Stufe und eventuell weitere vorgesehene Stufen ohne einen solchen Pegelverschieber auskommen. Allerdings empfiehlt es sich den Eingangspegelverschieber PS dann an die Zahl der vorgesehenen Teilerstufen anzupassen, was durch in den Emitterzweigen der beiden Pegelverschiebungstransistoren P1 und P2 vorgesehenen Dioden D* in noch zu beschreibender Weise geschehen kann.

Wie aus Fig. 4 ersichtlich hat man bei einem zweistufigen Frequenzteiler gemäß der Erfindung einen durch eine Konstantstromquelle S mit dem Strom 2I beaufschlagten Eingangsteil E, der entsprechend Fig. 2 bzw. 3 durch die beiden einen emittergekoppelten Differenzverstärker bildenden Transistoren 1 und 2 gegeben ist. Der durch die auszuwertende Taktfolge T gesteuerte Transistor 1 liegt dabei am Eingang e1 des zugehörigen Netzwerks N1, der durch die Emitter der Transistoren 3, 4, 9 und 10 gegeben ist. Der durch den invertierten Takt $\bar{T}$ gesteuerte Transistor 2 der Eingangsschaltung E liegt mit seinem Kollektor am Eingang e2 des Netzwerks N2, der durch die Emitter der Transistoren 5, 6, 7 und 8 gegeben ist. (In den Fig. 4 und 5 sind die in den einzelnen Netzwerken vorgesehenen Transistoren 3—10 jeweils zu einem Block zusammengefaßt, wobei die dem Masterteil und den Slaveteil zugehörigen Ausgängs A, $\bar{A}$, B, $\bar{B}$ bzw. Q und $\bar{Q}$ sowie die beiden Eingänge e1 und e2 angegeben sind. Die den vier Ausgängen jeweils zugeordneten Lastwiderstände sind hingegen auch in Fig. 4 und 5 gezeichnet und mit einer die jeweilige Wichtung ersichtlich machenden Bezeichnung R bzw. 2R usw, versehen.)

Die zu teilende Taktfolge T bzw. $\overline{T}$ liegt entweder unmittelbar oder besser (wie in Fig. 4 bzw. 5 dargestellt) unter Vermittlung eines Pegelverschiebungstransistors P1 bzw. P2 und je einer Diode D* an der Basis des Eingangstransistors 1 bzw. 2 der Eingangsschaltung E. Dabei liegt die Anode der Diode D* in beiden Fällen am Emitter des zugehörigen Pegelverschiebungstransistors P1 bzw. P2 und ihre Kathode im Falle der Beaufschlagung durch die Taktfolge T an der Basis des Transistors 1 bzw. im Falle der Beaufschlagung durch die invertierte Taktfolge $\overline{T}$ an der Basis des Transistors 2 der Eingangsschaltung E. Außerdem ist die Basis der Transistoren 1 und 2 jeweils über eine Konstantstromquelle St1 mit dem Strom $I_H$ vorsorgt, wie dies auch bei einer Schaltung gemäß Fig. 3 für die erste Stufe der Fall ist.

Wesentlich für die Erfindung ist nun, daß—wie aus Fig. 4 bzw. Fig. 5 ersichtlich—das die erste Teilerstufe bildende und von dem einzigen vorgesehenen Eingangsteil E mit der zu verarbeitenden Taktfolge T bzw. $\overline{T}$ beaufschlagte erste Netzwerk N1 mit seinem durch den Kollektor der Transistoren 8 und 10 gegebenen Ausgang B (also Q) dadurch zur Steuerung des die zweite Stufe bildenden Netzwerks N2 eingesetzt ist, indem dieser Ausgang über den zugehörigen Lastwiderstand R mit dem Eingang e1 des Netzwerks N2 verbunden ist. In entsprechender Weise ist der durch die Kollektoren der Transistoren 7 und 9 des Netzwerks N1 der ersten Stufe gegebene Ausgang $\overline{B}$ des Slaveteils dieser Stufe über den zugehörigen Lastwiderstand R mit dem Eingang e2 des die zweite Stufe bildenden Netzwerks N2 verbunden. Andererseits liegen die beiden dem Masterteil der ersten Stufe N1 zugeordneten Ausgänge A und $\overline{A}$ über den jeweils zugehörigen Lastwiderstand R an der Kathode einer Diode D, deren Anode unmittelbar mit der Quelle für das Versorgungspotential $V_{cc}$ verbunden ist.

Die vier Ausgängs A, $\overline{A}$, B, $\overline{B}$ des die zweite Teilerstufe bildenden Netzwerks N2 liegen über den über den jeweils zugehörigen Lastwiderstand 2R am Versorgungspotentiel $V_{cc}$. Die beiden Ausgängs B und $\overline{B}$ des Slaveteils in beiden Netzwerken N1 bzw. N2 bilden den Q- bzw. $\overline{Q}$-Ausgang der ersten bzw. der zweiten Teilerstufe der in Fig. 4 dargestellten Ausgestaltung der Erfindung. Schließlich ist noch zu erwähnen, daß auch die Kollektoren der beiden Pegelverschiebertransistoren P1 und P2 unmittelbar am Bezugspotential $V_{cc}$ liegen. Die vier Lastwiderstände haben bei der Ausgestaltung gemäß Fig. 4 bzw. Fig. 5 in dem die erste Stufe bildenden Netzwerk N1 jeweils den Wert R, im Netzwerk, das die zweite Teilerstufe bildet, den Wert 2R und im Falle des Vorhandenseins eines eine dritte Stufe darstellenden Netzwerks N3 (wie im Falle von Fig. 5) den Wert 4R usw.

Diese Wichtung entspricht auch den üblichen Vorgehen bei der Schaltung gemäß Fig. 3.

Beide Stufen der in Fig. 4 dargestellten Schaltung für einen zweistüfigen Frequenzteiler teilen die angelegte Eingangsfrequenz T bzw. $\overline{T}$ durch vier, so daß an Q-Ausgang bzw. an $\overline{Q}$-Ausgang des Netzwerks N2 eine Taktfolge T/4 bzw. $\overline{T}$/4 abgenommen werden kann. Für jede zuzätliche Stufe wird die Spannung einer Diodenstrecke benötigt, wie dies auch durch die Überbrückungsdiode zum Ausdruck gebrecht ist. Bei 5V Versorgungsspannung können, wenn der als Stromschalter wirkende Eingangsteil E und die Stromquelle S berücksichtigt werden, biz zu drei Stufen in Serie geschaltet werden, wie dies aus Fig. 5 ersichtlich ist. Damit hat man dann einen 1:5-Teiler.

Bei der in Fig. 5 im Blockschaltbild gezeigten Ausgestaltung eines der Erfindung entsprechenden dreistufigen Teilers entspricht die Anschaltung der zweiten Stufe N2 an die erste Stufe N1 der in Fig. 4 gezeigten Schaltung. Jedoch liegen die Lastwiderstände der zweiten Stufe N2 nicht an der Klemme für das Vorsorgungspotential $V_{cc}$ wie im Falle von Fig. 4, sondern in einer den Ausgängen der Eingangsstufe N1 entsprechenden Weise an den Eingängen e1 und e2 der dritten Stufe N3. Erst die Lastwiderstände dieser dritten Stufe, die alle den vierfachen Grundwert, also den Widerstandswert 4R haben und dementsprechend bezeichnet sind, liegen an der Klemme für das Versorgungspotential $V_{cc}$. Die Lastwiderstände 2R der zweiten Stufe, also des Netzwerks N2, sind hingegen in einer dem Netzwerks N1 in Fig. 4 entsprechenden Weise geschaltet. Dies bedeutet, daß die Ausgange A und $\overline{A}$ über den jeweils zugehörigen Lastwiderstand 2R an die Kathode der zu N2 gehörenden Diode D gemeinsam angeschlossen sind, deren Anode an der Klemme für das Versorgungspotential $V_{cc}$ liegt. Andererseits liegen der Slaveausgang B über den zugehörigen Lastwiderstand 2R am Eingang e1 und der Slaveausgang $\overline{B}$ am Eingang e2 des die dritte Teilerstufe bildenden Netzwerks N3. Schließlich ist die mit ihrer Kathode über den jeweiligen Lastwiderstand R an die beiden Ausgänge A und $\overline{A}$ des Master-Flip-Flops der ersten Teilerstufe N1 liegende Diode—im Gegensatz zu Fig. 4 mit ihrer Anode nicht unmittelbar an das Versorgungspotential $V_{cc}$ angeschlossen sondern liegt an den beiden Ausgängen A und $\overline{A}$ des Master-Flip-Flops der zweiten Stufe unter Vermittlung der diesen beiden Ausgängen A und $\overline{A}$ jeweils angehörenden Lastwiderstände 2R der zweiten Stufe N2. Somit bilden die beiden Dioden D der Ausgestaltung gemäß Fig. 5 die aus Fig. 5 ersichtliche Reihenschaltung. Um außerdem dem in Vergleich zur Schaltung gemäß Fig. 4 höheren Spannungsabfall bei einer Schaltung gemäß Fig. 5 auch im Pegelverschieber PS Rechnung zu tragen sind im Falle des dreistufigen Teilers gemäß Fig. 5 die Emitter der beiden Pegelverschiebungstransistoren P1 und P2 jeweils über ein Paar gleichgerichteter Dioden D* mit der jeweils zugeordneten Konstantstromquelle St1 verbunden.

Man erkennt aufgrund der bisherigen Beschreibung unmittelbar, daß man zur Realisierung eines $1:2^{(n+1)}$-Teilers eine Anzahl n von Netzwerken der beschriebenen Art hintereinanderschalten kann, die von einem gemeinsamen Eingangsteil E gesteuert werden. Die Versorgungsspannung muß allerdings der Anzahl der hintereinander geschalteten Netzwerke in der bereits oben angedeuteten Weise angepaßt werden. In Verallgemeinerung der anhand von Fig. 4 und 5 hat man dann folgende Merkmale:

a) Die letzte Stufe, also das Netzwerk $N_n$, liegt mit allen ihren Lastwiderständen an der Klemme für das Versorgungspotential.

b) Mit Ausnahme des vom Eingangsteil E gesteuerten Netzwerks N1 liegen alle übrigen Netzwerke mit ihrem Eingang e1 über einen zum vorherigen Netzwerk gehörenden Lastwiderstand am Q-Ausgang (=B) der jeweils vorherigen Stufe. Ebenso liegen sie mit ihrem Eingang e2 über einen Lastwiderstand des vorherigen Netzwerks an dessen $\bar{Q}$-Ausgang (=$\bar{B}$).

c) Die Lastwiderstände der verschiedenen Netzwerke sind binär gewichtet. Ist in der mit dem am Eingangsteil E liegenden Netzwerk N1 beginnenden Nummerierung das betrachtete Netzwerk das p-te Netzwerk (also das Netzwerk Np), so sind dessen vier Lastwiderstände auf den Wert $2^p.R$ eingestellt, wobei der Grundwert der Lastwiderstände, d.h. der Widerstandswert der Lastwiderstände des ersten Netzwerks N1, mit R bezeichnet ist.

d) Jedem der in der Kette vorgesehenen Netzwerke Np ist je eine Diode D zugeordnet, deren Kathode an die beiden zum Masterteil gehörenden Ausgänge A bzw. $\bar{A}$ des jeweils vorangehenden Netzwerks N(p−1) der Kette unter Verwendung je eines Lastwiderstands des Netzwerks N(p−1) (also eines Lastwiderstands von Wert $2^{p−1}.R$) gelegt ist, während ihre Anode an die beiden zum Masterteil des Netzwerks Np gehörenden Ausgänge—ebenfalls unter Verwendung eines Lastwiderstands und zwar diesmal des Netzwerks Np (also eines Widerstands $2^p.R$)—a und $\bar{A}$ geschaltet ist.

e) Der Emitter der beiden Pegelverschiebungstransistoren P1 und P2 ist durch die Reihenschaltung von (n−1) Dioden D* mit dem jeweils zugehörigen Eingang 1 bzw. 2 des Eingangsteils E als auch mit dem Ausgang der zugehörigen Stromquelle St1 verbunden, wie dies auch aus Fig. 4 bzw. 5 für den Fall n=2 bzw. n=3 ersichtlich ist.

Es ist verständlich, daß anstelle der Überbrückungsdioden D für den die einzelnen Netzwerke überbrückenden Schaltungsteile auch ggf. andere bezüglich des Spannungsabfalls und dessen Temperaturgang dem Netzwerk entsprechende andere Schaltungsteile, z.B. je ein zweites Netzwerk, verwendet werden könnte, z.B. wenn man noch zusätzlich phasenverschobene geteilte Taktfolgen ableiten möchte. Im allgemeinen stellen jedoch Dioden, die durch je einen als Diode geschalteten Transistor gegeben sind, das Optimum dar.

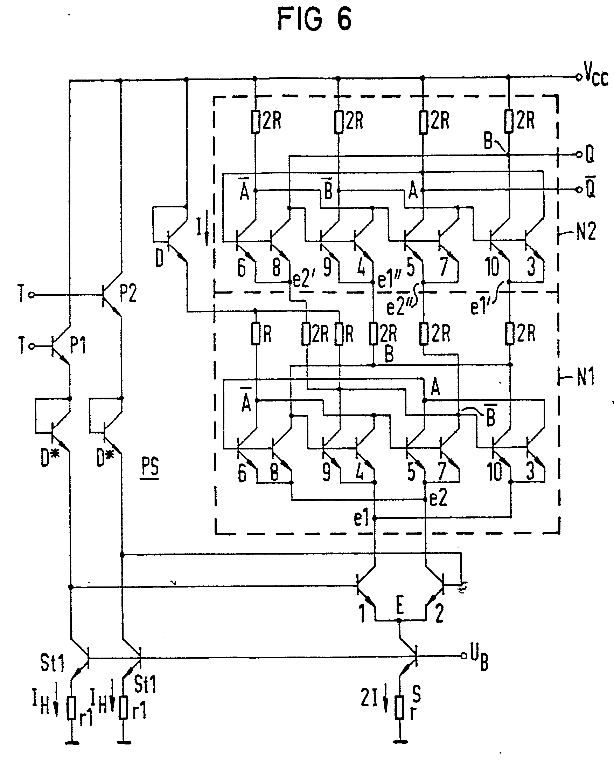

Bei der in Fig. 6 gebrachten detaillierten Darstellung eines zweistufigen Frequenzteilers gemäß der vorliegenden Erfindung ist dies der Fall. Dort sind auch die Stromquelle S für den Eingangsteil E und die beiden Stromquellen St1 für den Pegelverschieber PS durch je einen npn-Transistor dargestellt, der über einen Emitterwiderstand r bzw. r1 mit dem Bezugspotential (Masse) verbunden ist wobei die Basisanschlüsse der drei Stromquelletransistoren S bzw. St1 von einem gemeinsamen Potential $U_B$ angesteuert und die Ausgänge durch den Kollektor des jeweiligen Stromquellentransistors gegeben sind. Durch die Bemessung der Emitterwiderstände r bzw. r1 werden dann die Ströme 2I bzw. $I_H$ eingestellt.

Hinsichtlich der Ansteuerung des die erste Teilerstufe bildenden ersten Netzwerks N1 durch die Eingangsstufe E besteht Übereinstimmung mit Fig. 4 bzw. Fig. 5. Hingegen werden Master und Slave der zweiten Teilerstufe von der ersten Teilerstufe getrennt angesteuert, was mitunter erwünscht sein kann. Dies bedeutet, daß der Ausgang B über einen ersten Lastwiderstand 2R den durch die Emitter der Transistoren 3 und 10 gegebenen Teil e1' und über einen zweiten Lastwiderstand 2R den Teil e1'' des Eingangs e1 des Netzwerks N2 ansteuert, der durch die Emitter der Transistoren 4 und 9 gegeben ist. In entsprechender Weise ist auch der Eingang e2 des zweiten Netzwerks N2 in zwei Teileingänge e2' und e2'' aufgespalten, die über je einen Lastwiderstand 2R mit dem Ausgang $\bar{B}$ des ersten Netzwerks N1 verbunden sind. Bei der Ausgestaltung gemäß Fig. 6 hat also das Netzwerk N1 vier Lastwiderstände 2R und zwei Lastwiderstände R. Letztere dienen der Verbindung der Masterausgänge A und $\bar{A}$ zur Überbrückungsdiode D, die durch einen als Diode geschalteten Transistor gegeben ist. Dasselbe ist für die Dioden D* im Pegelshifter PS der Fall. Die Aufspaltung der Eingänge e1 und e2 und der zugehörigen Lastwiderstände R in zwei "parallele Lastwiderstände" 2R ist jedoch im allgemeinen nicht erforderlich.

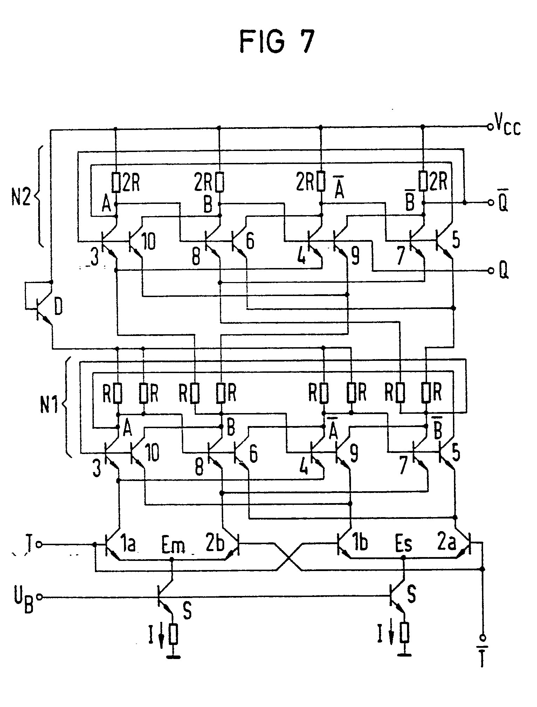

Bei dem detaillierten Schaltbild gemäß Fig. 7 handelt is sich um einen zweistufigen Teiler gemäß der Erfindung, bei dem der Eingangsteil E entsprechend Fig. 1 in einen für die Steuerung des Masterteils zuständigen Teil Em und in einen für die Steuerung des Slaveteils zuständigen Teil Es aufgespaltet ist. Die Steuerung der Transistoren 3—10 im Netzwerk N1 der ersten Stufe entspricht völlig den aus Fig. 1 ersichtlichen Verhältnissen, während für die Steuerung des die zweite Stufe bildenden Netzwerks N2 die Ausgänge B und $\bar{B}$ des ersten Netzwerks über die zuständigen Lastwiderstände R zuständig sind. Die Ausgänge A und $\bar{A}$ liegen über die zugehörigen Lastwiderstände und über die Diode D am Versorgungspotential $V_{cc}$, das auch für die Versorgung der Kollektoren der Widerstände 3—10 im Netzwerk N2 der zweiten Teilerstufe zuständig ist. Die die beiden Eingangsschaltungsteile Em und Es steuernden Taktimpulsfolgen T und $\bar{T}$ werden zweckmäßig über einen (nicht gezeichneten) Pegelverschieber PS zugeführt, der entsprechend Fig. 4 bzw. Fig. 6 ausgebildet ist.

Man kann nun ohne weiteres unter Anwendung der Erfindung einen Teiler entsprechend der vorliegenden Erfindung, z.B. entsprechend Fig. 4 oder Fig. 5 dazu verwenden, daß die z.B. am Q- bzw. $\bar{Q}$-Ausgang seiner letzten Stufe N2 bzw. N3 abgegebenen Impulse—insbesondere eines Eingangspegelverschiebers PS—die Takte T und $\bar{T}$ für die Eingangsschaltung E eines weiteren Frequenzteilers, insbesondere eines Frequenzteilers nach der Erfindung verwendet werden, der seinerseits unabhängig von dem steuernden Frequenzteiler an das Versorgungspotential $V_{cc}$ gelegt ist. Beispielsweise kann man auf diese Weise eine beliebige Anzahl n von Fig. 4 entsprechenden, also aus den. Netzwerken N1 und N2 und den zugehörigen Eingangsteil E bestehenden Anordnungen kettenförmig unter Zwischenschaltung je eines Pegelverschiebers PS hintereinander schalten, um auf diese Weise einen $1:4^n$-Teiler zu erhalten.

Schließlich ist noch zu erwähnen, daß jede der Erfindung entsprechenden Schaltungen auch als asynchroner binärer Zähler vom Ripple-carry-Typ verwendet werden kann.

## Patentansprüche

1. Integrierbare Halbleiterschaltung für einen Frequenzteiler, der mittels nach dem Master-Slave-Prinzip arbeitenden bistabilen Kippstufen unter Verwendung von Transistoren vom selben Typ und Widerständen aufgebaut ist, bei der eine aus den zu verarbeitenden und einander gleichen Impulsen bestehende Signalfolge an den Eingang einer durch einen Differenzverstärker gebildeten Eingangsschaltung (E) gelegt und der Differenzverstärker durch zwei Transistoren gegeben ist, deren Stromeingangselektroden miteinander sowie über eine Konstantstromquelle mit dem das Bezugspotential führenden Versorgungsanschluß verbunden sind, während ihre Stromausgangselektroden über aus weiteren Transistoren sowie aus Widerständen gebildete Netzwerke (N1, N2, N3) mit dem das Versorgungspotential führenden Versorgungsanschluß ($V_{cc}$) der Schaltung verbunden sind, bei der die Netzwerke derart ausgestaltet sind, daß sie zusammen mit der Eingangsschaltung (E) nach dem Master-Slave-Prinzip arbeitende, jeweils eine Teilerstufe darstellende bestabile Kippstufen ergeben, an deren beiden Ausgängen das von der jeweiligen Kippstufe gelieferte Ergebnis in Form von Impulsen abnehmbar ist, wobei die Eingänge von aufeinanderfolgenden Teilerstufen entsprechenden Netzwerken über je einen zum vorhergehenden Netzwerk gehörenden Lastwiderstand (R, 2R, 4R) an die das nicht invertierte Signal bereitstellenden Ausgänge des Slave-Teiles des jeweiligen vorherigen Netzwerkes angeschlossen sind und die Lastwiderstände (2R, 4R) des letzten Netzwerkes (N2, N3) mit dem Versorgungspotential verbunden sind, dadurch gekennzeichnet, daß die zum Slaveteil jeder bistabilen Kippstufe gehörenden beiden Ausgänge (B, $\bar{B}$) des entsprechenden Netzwerks (N1, N2) über den jeweils zugehörigen Lastwiderstand (R, 2R) in diesem Netzwerk (N1) unmittelbar an je einen der beiden Eingänge (e1, e2) des nachfolgenden Netzwerks (N2, N3), welche den beiden durch die Eingangsschaltung (E) beaufschlagten Eingängen (e1, e2) des ersten Netzwerks (N1) entsprechen, gelegt sind und daß die zum Masterteil der bistabilen Kippstufe gehörenden beiden Ausgänge (A, $\bar{A}$) des jeweils entsprechenden Netzwerks (N1, N2) über die zugeordneten Lastwiderstände (R, 2R) und ein Pegelverschiebungselement (D) an den Versorgungsanschluß für das Versorgungspotential ($V_{cc}$) gelegt sind.

2. Halbleiterschaltung nach Anspruch 1, dadurch gekennzeichnet, daß der Versorgungsanschluß für das Versorgungspotential ($V_{cc}$) unmittelbar an allen Lastwiderständen (2R) des zweiten Netzwerks (N2) und außerdem an der Anode einer das Pegelverschiebungselement bildenden Diode (D) liegt, deren Kathode jeweils über den entsprechenden Lastwiderstand (R) mit den beiden Ausgängen (A, $\bar{A}$) des Masterteils des ersten Netzwerks (N1) verbunden ist (Fig. 4).

3. Halbleiterschaltung nach Anspruch 1, dadurch gekennzeichnet, daß zwischen dem Versorgungsanschluß für das Versorgungspotential ($V_{cc}$) und dem zweiten Netzwerk (N2) sowohl ein dem ersten Netzwerk (N1) als auch dem zweiten Netzwerk (N2) schaltungsmäßig entsprechendes drittes Netzwerk (N3) vorgesehen und mit seinen Lastwiderständen (4R) unmittelbar an den Anschluß für das Versorgungspotential ($V_{cc}$) gelegt ist, während seine beiden Eingänge (e1, e2) mit je einem der beiden dem Slaveteil des zweiten Netzwerks (N2) zugehörenden Signalausgängen (B, $\bar{B}$) über deren Lastwiderstand (2R) verbunden ist, während die Verbindung der beiden Ausgänge (A, $\bar{A}$) des Masterteils des ersten Netzwerks (N1) sowie des zweiten Netzwerks (N2) zum Versorgungspotential ($V_{cc}$) durch je eine Diode (D) gegeben ist, indem diese beiden Ausgänge (A, $\bar{A}$) des ersten Netzwerks über den jeweils zugehörigen Lastwiderstand (R) an die Kathode der ersten Diode (D) und die beiden Ausgänge (A, $\bar{A}$) des Masterteils des zweiten Netzwerks (N2) an die Kathode der zweiten Diode über den jeweils zugehörigen Lastwiderstand (2R) gelegt und außerdem die Anode dieser zweiten Diode (D) unmittelbar mit dem das Versorgungspotential ($V_{cc}$) führenden Versorgungsanschluß verbunden ist, während die Anode der mit den Masterausgängen (A, $\bar{A}$) des ersten Metzwerks (N1) verbundenen Diode (D) an der Kathode der zweiten Diode (D) liegt. (Fig. 5).

4. Halbleiterschaltung nach einem der Ansprüche 1 bis 3, dadurch gekennzeichnet, daß die an den Masterausgängen (A, $\bar{A}$) und an den Slaveausgängen (B, $\bar{B}$) der hintereinander geschalteten Netzwerke innerhalb der einzelnen Netzwerke (N1, N2, N3,...) übereinstimmende Widerstandswerte haben, daß aber die Widerstandswerte der Lastwiderstände mit wachsendem Abstand des einzelnen Netzwerks von der Eingangsschaltung (E) binär gewichtet sind.

5. Halbleiterschaltung nach Anspruch 1 oder 4, dadurch gekennzeichnet, daß die Verbindung des ersten Netzteils (N1) zum Versorgungspotentiel ($V_{cc}$) über eine Kette von n hintereinander geschalteten und und dem ersten Netzwerk (N1) in schaltungsmäßiger Hinsicht gleicher Netzwerke (N2, N3,...Nn) gegeben ist, daß dabei die dem Slaveteil des in der Kette jeweils vorausgehenden Netzwerks ($N_{p-1}$) zugehörigen beiden Ausgänge (B, $\bar{B}$) über den jeweils zugehörigen Lastwiderstand an die beiden Eingänge (e1, e2) des jeweils folgenden Netzwerks ($N_p$) gelegt sind, während die dem Masterteil des jeweils unmittelbar vorherigen Netzwerks ($N_{p-1}$) gehörenden Ausgänge (A, $\bar{A}$) über den zugehörigen Lastwiderstand und einen hinsichtlich seines Spannungsabfalls an den Spannungsabfall längs des die zugehörigen Slaveausgänge (B, $\bar{B}$) ausschließlich unter Vermittlung der folgenden Netzwerks ($N_{p+1}$,...Nn) verbindenden Schaltungswegs angeglichenen Schaltungsteil ebenfalls mit dem Versorgungspotential ($V_{cc}$) verbunden sind.

6. Halbleiterschaltung nach einem der Ansprüche 1, 3 und 5, dadurch gekennzeichnet, daß die Verbindung zwischen den beiden Masterausgangen (A, $\bar{A}$) der einzelnen Netzwerks (N1, N2,...$N_{n-1}$) zum Versorgungspotential ($V_{cc}$) dadurch gegeben ist, daß jedem Netzwerk der Kette mit Ausnahme des letzten und mit seinen vier Ausgängen (A, $\bar{A}$, B, $\bar{B}$) über dem jeweils zugehörigen Lastwiderstand am Versorgungspotential ($V_{cc}$) liegenden Netzwerks (Nn) jeweils eine Diode (D) zugeordnet ist, die mit ihrer Kathode mit den beiden Ausgängen (A, $\bar{A}$) des Masterteils des betreffenden Netzwerks (Np) unter Vermittlung der beiden zu den betreffenden Ausgängen (A, $\bar{A}$) gehörenden Lastwiderstände ($R \cdot 2^{(p-1)}$) verbunden ist, während die Anode dieser Diode (D) an die entsprechenden Ausgänge des jeweils unmittelbar folgenden Netzwerks ($N_{p+1}$) unter Vermittlung des den betreffenden Ausgang (A bzw. $\bar{A}$) des folgenden Netzwerks zugeordneten Lastwiderstands ($R.2^p$) gelegt ist.

7. Halbleiterschaltung nach einem der Ansprüche 1 bis 6, dadurch gekennzeichnet, daß die zu verarbeitenden Impulse den beiden Eingängen (1, 2) der Eingangsschaltung (E) in Form zweier zueinander invertierter Impulsfolgen (T bzw. $\bar{T}$) zugeführt sind, wobei die eine Impulsfolge für den einen Eingang (1) und die andere für den anderen Eingang (2) zuständig ist, daß hierzu die eine Impulsfolge (D) an die Steuerelektrode eines Pegelverschiebertransistors (P1) und die andere Impulsfolge ($\bar{T}$) an die Steuerelektrode eines weiteren Pegelverschiebertransistors (P2) gelegt ist, deren Stromausgangselektrode am Versorgungspotential ($V_{cc}$) und deren Stromeingangelektrode über eine Serie von (n–1) hintereinander geschalteter Dioden (D*) einerseits an den zu steuernden Eingang (1, bzw. 2) der Eingangsschaltung (E) und andererseits über je eine Stromquelle an das Bezugspotential gelegt ist, und daß dabei n die Anzahl der hintereinander geschalteten Netzwerke (N1, N2...Nn) bedeutet.

8. Halbleiterschaltung nach einem der Ansprüche 1 bis 7, dadurch gekennzeichnet, daß sié mit einer ihr gleichen Halbleiterschaltung eine Kette bildet, indem die beiden zum Slaveteil eines der hintereinander geschalteten Netzwerke (N1, N2,...Nn) (insbesondere des letzten Netzwerks (Nn)) gehörenden Ausgänge (B, $\bar{B}$) zur Steuerung je eines der beiden Eingänge (1, 2) des Eingangsteils (E) der anderen Halbleiterschaltung verwendet sind.

9. Halbleiterschaltung nach einem der Ansprüche 1 bis 8, dadurch gekennzeichnet, daß die in ihr verwendeten Transistoren und Dioden durch je einen npn-Transistor gegeben und diese npn-Transistoren einander gleich sind.

**Revendications**

1. Circuit à semi-conducteurs intégrables pour un diviseur de fréquence, qui est constitué à l'aide d'étages à bascule opérant selon le principe maître-esclave avec mise en oeuvre de transistors d'un même type et de résistances, dans lequel un train d'impulsions constitué par des impulsions à traiter et identiques entre elles, est appliqué à l'entrée d'un circuit d'entrée (E) formé par un amplificateur différentiel constitué par deux transistors dont les électrodes d'entrée du courant sont reliées entre elles ainsi que, par l'intermédiaire d'une source de courant constant, à la borne d'alimentation qui est portée au potentiel de référence, alors que leurs électrodes de sortie du courant sont reliées, par l'intermédiaire de réseaux (N1, N2, N3) formés par d'autres transistors ainsi que par des résistances, à la borne d'alimentation ($V_{cc}$) di circuit, portée au potentiel d'alimentation, circuit dans lequel les réseaux sont constituées de telle façon qu'ils forment ensemble avec le circuit d'entrée (E) des étages à bascule bistables dont chacune opére selon le principe maître-esclave, un étage-diviseur, aux deux sorties duquel on peut prélever, sous la forme d'impulsions, le résultat fourni par l'étage à bascule considéré, la réalisation étant telle que les entrées des réseaux des étages-diviseurs qui se succèdent sont reliées, respectivement par l'intermédiaire d'une résistance de charge (R, 2R, 4R) appartenant au réseau précédent, aux sorties de la partie esclave du réseau précédent, alors que les résistances (2R, 4R) du dernier réseau (N2, N3) sont reliées au potentiel d'alimentation, caractérisé par le fait que les deux sorties (B, $\bar{B}$) du réseau correspondant (N1, N2) qui appartiennent à la partie esclave de chaque étage à bascule bistable sont reliées, par l'intermédiaire de la résistance de charge (R, 2R) appartenant respectivement à ce réseau (N1), directement et respectivement à l'une des deux entrées (e1, e2) du réseau suivant (N2, N3), qui correspondent aux deux entrées (e1, e2) du premier réseau (N1) qui sont chargées par le circuit d'entrée (E), et que les deux sorties (A, $\bar{A}$) du réseau correspondant (N1, N2) et qui appartiennent à la partie maître de l'étage à bascule bistable, sont reliées, par l'intermédiaire des résistances de charge associées (R, 2R) et d'un élément de décalage du niveau (D), à la borne d'alimentation pour le potentiel d'alimentation ($V_{cc}$).

2. Circuit à semi-conducteur selon la revendication 1, caractérisé par le fait que la borne d'alimentation pour le potentiel d'alimentation ($V_{cc}$) est reliée directement à toutes les résistances de charge (2R) du second réseau (N2) et, en outre, à l'anode d'une diode (D) qui constitue l'élément de décalage du niveau et dont la cathode est reliée, par l'intermédiaire de la résistance de charge correspondante (R), aux deux sorties (A, $\overline{A}$) de la partie maître du premier réseau (N1) (Fig. 4).

3. Circuit à semi-conducteurs selon la revendication 1, caractérisé par le fait qu'entre la borne d'alimentation pour le potentiel d'alimentation ($V_{cc}$) et le second réseau (N2), il est prévu un troisième réseau (N3) qui correspond au point de vue du montage aussi bien au premier réseau (N1) qu'au second réseau (N2), et qui est relié, par ses résistances de charge (4R) directement à la borne pour le potentiel d'alimentation ($V_{cc}$), alors que ses deux entrées (e1, e2) sont respectivement reliées à l'une des deux sorties des signaux (B, $\overline{B}$) appartenant à la partie esclave du second réseau (N2), par l'intermédiaire de leurs résistances de charge, et que la liaison des deux sorties (A, $\overline{A}$) de la partie maître du premier réseau (N1) ainsi que du second réseau (N2) avec le potentiel d'alimentation ($V_{cc}$) est réalisée respectivement par une diode (D), la réalisation étant telle que ces deux sorties (A, $\overline{A}$) du premier réseau sont reliées par la résistance de charge associée (R) à la cathode de la première diode (D), alors que les deux sorties (A, $\overline{A}$) de la partie maître du second réseau (N2) sont reliées à la cathode de la seconde diode par l'intermédiaire de la résistance de charge associée (2R), et qu'en outre l'anode de cette seconde diode (D) est reliée directement à la borne d'alimentation portée au potentiel d'alimentation ($V_{cc}$) et que l'anode de la diode (D) qui est reliée aux sorties (A, $\overline{A}$) de la partie maître, est reliée à la cathode de la seconde diode (D) (Fig. 5).

4. Circuit à semi-conducteurs selon l'une des revendications 1 à 3, caractérisé par le fait que les réseaux montés l'un derrière l'autre et reliée aux sorties-maîtres (A, $\overline{A}$) et aux sorties-esclaves (B, $\overline{B}$), possèdent dans les divers réseaux (N1, N2, N3,...) des valeurs ohmiques concordantes, alors que les valeurs ohmiques des résistances de charge sont pondérées binairement pour des distances croissantes entre les réseaux individuels et le circuit d'entrée (E).

5. Circuit à semi-conducteurs selon la revendication 1 ou 4, caractérisé par le fait que la liaison du premier réseau (N1) avec le potentiel d'alimentation ($V_{cc}$) est réalisée par l'intermédiaire d'une chaîne de n réseaux (N2, N3,...Nn) montés l'un derrière l'autre et présentant des montages identiques à celui du premier réseau (N1), que les deux sorties (B, $\overline{B}$) qui appartiennent à la partie esclave du réseau précédent ($N_{p-1}$) de la chaîne, sont reliées, par l'intermédiaire de la résistance de charge associée, aux deux entrées (e1, e2) du réseau ($N_p$) immédiatement suivant, alors que les sorties (A, $\overline{A}$) qui appartiennent à la partie-maître du réseau immédiatement précédent ($N_{p-1}$) sont également reliées au potentiel d'alimentation, par l'intermédiaire de la résistance de charge associée et d'une partie du circuit qui est, du point de vue de sa chute de tension, adaptée à la chute de tension le long de la voie du circuit qui relie les sorties-esclaves (B, $\overline{B}$) exclusivement à l'aide des réseaux suivants ($N_{p+1}$,...Nn).

6. Circuit à semi-conducteurs selon l'une des revendications 1, 3 et 5, caractérisé par le fait que la liaison entre les deux sorties-maîtres (A, $\overline{A}$) des différents réseaux (N1, N2,...$N_{n-1}$) et le potentiel d'alimentation ($V_{cc}$) est réalisée grâce au fait qu'à chaque réseau de la chaîne, à l'exception du dernier réseau (Nn) relié par ses quatre sorties (A, $\overline{A}$, B, $\overline{B}$), et par l'intermédiaire de la résistance de charge associée, portée au potentiel d'alimentation ($V_{cc}$), est associée une diode (D) qui est reliée, par sa cathode, aux deux sorties (A, $\overline{A}$) de la partie maître du réseau concerné ($N_p$), par l'intermédiaire des deux résistances de charge ($R.2^{(p-1)}$) qui appartiennent aux sorties concernées (A, $\overline{A}$), alors que l'anode de cette diode (D) est reliée aux sorties correspondantes du réseau immédiatement suivant ($N_{p-1}$), par l'intermédiaire de la résistance de charge ($R.2^p$) associée à la sortie concernée (A ou $\overline{A}$) du réseau suivant.

7. Circuit à semi-conducteur selon l'une des revendications 1 à 6, caractérisé par le fait que les impulsions à traiter des deux entrées (1, 2) du circuit d'entrée (E) sont appliquées sous la forme de deux trains d'impulsions (T, $\overline{T}$) inversés l'un par rapport à l'autre, l'un des trains d'impulsions valant pour l'une (1) des entrées et l'autre pour la seconde entrée (2), qu'à cet effet l'un (T) des trains d'impulsions est appliqué à l'électrode de commande d'un transistor (P1) de décalage du niveau et l'autre train d'impulsions ($\overline{T}$) est appliqué à l'électrode de commande d'un second transistor (P2) de décalage du niveau, dont l'électrode de sortie du courant est portée au potentiel d'alimentation (Vcc) et dont l'électrode de l'entrée du courant est reliée, par l'intermédiaire d'une série de $(n-1)$ diodes (D*) montées en série, d'une part, à l'entrée (1, ou 2) du circuit d'entrée qui est à commander, et, d'autre part, par l'intermédiaire d'une source de courant, au potentiel de référence, et que dans ce cas n désigne le nombre de réseaux (N1, N2,...Nn) qui sont montés l'un à la suite de l'autre.

8. Circuit à semi-conducteur selon l'une des revendications 1 à 7, caractérisé par le fait qu'il forme avec un circuit à semi-conducteurs qui lui est identique, une chaîne grâce au fait que les deux sorties (B, $\overline{B}$) qui appartiennent à la partie esclave de l'un des réseaux (N1, N2,...Nn) montés l'un derrière l'autre (en particulier du dernier réseau (Nn)), sont utilisées pour commander respectivement l'une des deux entrées (1, 2) de la partie entrée de l'autre circuit à semi-conducteurs.

9. Circuit à semi-conducteurs selon l'une des revendications 1 à 8, caractérisé par le fait que les transistors et diodes qui y sont mis en oeuvre sont constitués chacun par un transistor npn et que ces transistors npn sont identiques entre eux.

## Claims

1. Integrable semi-conducteur circuit for a frequency divider which is constructed by means of bistable flip-flops operating according to the master-slave principle using transistors of the same type and resistors, in which semi-conductor circuit a signal sequence consisting of the pulses to be processed which are identical to one another is applied to the input of an input circuit (E) formed by a differential amplifier and the differential amplifier is formed by two transistors, the current input electrodes of which are connected to one another and via a constant current source to the supply terminal conducting the reference potential, whilst their current output electrodes are connected via networks (N1, N2, N3) formed from further transistors and from resistors to the supply terminal ($V_{cc}$), conducting the supply potential, of the circuit, in which the networks are constructed in such a way that, together with the input circuit (E), they produce bistable flip-flops operating according to the master-slave principle and in each case representing a divider stage, at the two outputs of which flip-flops the result supplied by the respective flip-flop can be tapped off in the form of pulses, the inputs of networks corresponding to successive divider stages being each connected via one load resistor (R, 2R, 4R) belonging to the preceding network, to the outputs, providing the non-inverted signal, of the slave part of the respective previous network, and the load resistors (2R, 4R) of the last network (N2, N3) being connected to the supply potential, characterised in that the two outputs (B, $\overline{B}$), belonging to the slave part of each bistable flip-flop, of the corresponding network (N1, N2) are each connected via the, in each case, respective load resistor (R, 2R) in this network (N1) directly to one of the two inputs (e1, e2) of the following network (N2, N3), which inputs correspond to the two inputs (e1, e2) supplied by the input circuit (E), of the first network (N1) and in that the two outputs (A, $\overline{A}$), belonging to the master part of the bistable flip-flop, of the respective corresponding network (N1, N2) are connected via the allocated load resistors (R, 2R) and a level shifter (D) to the supply terminal for the supply potential ($V_{cc}$).

2. Semi-conductor circuit according to Claim 1, characterized in that the supply terminal for the supply potential ($V_{cc}$) is connected directly, to all load resistors (2R) of the second network (N2) and in addition to the anode of a diode (D) forming the level shifter, the cathode of which is connected in each case via the corresponding load resistor (R) to the two outputs (A, $\overline{A}$) of the master part of the first network (N1) (Fig. 4).

3. Semi-conductor circuit according to Claim 1, characterized in that, between the supply terminal for the supply potential ($V_{cc}$) and the second network (N2) a third network is provided which corresponds in terms of circuitry both to the first network (N1) and to the second network (N2) and is connected by its load resistors (4R) directly to the terminal for the supply potential ($V_{cc}$), whilst its two inputs (e1, e2) are connected to one each of the two signal outputs (B, $\overline{B}$) belonging to the slave part of the second network (N2) via their load resistor (2R), whilst the connection of the two outputs (A, $\overline{A}$) of the master part of the first network (N1) and of the second network (N2) to the supply potential ($V_{cc}$) is formed by one diode (D) each by connecting these two outputs (A, $\overline{A}$) of the first network via the, in each case, respective load resistor (R) to the cathode of the first diode (D) and by connecting the two outputs (A, $\overline{A}$) of the master part of the second network (N2) to the cathode of the second diode via the, in each case, respective load resistor (2R) and in addition by connecting the anode of this second diode (D) directly to the supply terminal conducting the supply potential ($V_{cc}$), whilst the anode of the diode (D) connected to the master outputs (A, $\overline{A}$) of the first network (N1) is connected to the cathode of the second diode (D). (Fig. 5).

4. Semi-conductor circuit according to one of Claims 1 to 3, characterized in that the (sic) at the master outputs (A, $\overline{A}$) and at the slave outputs (B, $\overline{B}$) of the networks connected in series have corresponding resistance values within the individual networks (N1, N2, N3,...) in that, however, the resistance values of the load resistors are binarily weighted with increasing distance of the individual network from the input circuit (E).

5. Semi-conductor circuit according to Claim 1 or 4, characterized in that the connection of the first network part (N1) to the supply potential ($V_{cc}$) is formed by a chain of n networks (N2, N3,...Nn) connected in series and identical in terms of circuitry to the first network (N1), in that the two outputs (B, $\overline{B}$) belonging to the slave part of the, in each case, preceding network ($N_{p-1}$) in the chain are connected via the, in each case, respective load resistor to the two inputs (e1, e2) of the, in each case, following network ($N_p$), whilst the outputs (A, $\overline{A}$) belonging to the master part of the, in each case, directly preceding network ($N_{p-1}$) are likewise connected ho the supply potential ($V_{cc}$) via the respective load resistor and a circuit part which is matched, in respect of its voltage drop, to the voltage drop along the circuit path connecting the respective slave outputs (B, $\overline{B}$) exclusively through the following networks ($N_{p+1},...N_n$).

6. Semi-conductor circuit according to one of Claims 1, 3 and 5, characterized in that the connection between the two master outputs (A, $\overline{A}$) of the individual networks (N1, N2,...$N_{n-1}$) to the supply potential ($V_{cc}$) is formed by each network of the chain, with the exception of the last network (Nn), the four outputs (A, $\overline{A}$, B, $\overline{B}$) of which are connected via the, in each case, respective load resistor to the supply potential ($V_{cc}$) having in each case a diode (D) allocated to it, which is connected by its cathode to the two outputs (A, $\overline{A}$) of the master part of the relevant network (NP) through the two load resistors ($R \cdot 2^{(p-1)}$) belonging to the relevant outputs (A, $\overline{A}$), whilst the anode of this diode (D) is connected to the corresponding outputs of the, in each case, directly following network ($N_{p-1}$) through the load resistor ($R \cdot 2^p$) allocated to the relevant output (A or $\overline{A}$) of the following network.

7. Semi-conductor circuit according to one of Claims 1 to 6, characterized in that the pulses to be processed are fed to the two inputs (1, 2) of the input circuit (E) in the form of two pulse sequences (T or $\overline{T}$) which are inverted in relation to one another, the one pulse sequence being responsible for the one input (1) and the other for the other input (2), in that, for this purpose, the one pulse sequence (T) is connected to the control electrode of a level shifting transistor (P1) and the other pulse sequence ($\overline{T}$) is connected to the control electrode of a further level shifting transistor (P2), the current output electrode of which is connected to the supply potential ($V_{cc}$) and the current input electrode of which is connected via a series of (n−1) diodes (D*) connected in series, on the one hand, to the input (1, or 2) to be controlled, of the input circuit (E) and, on the other hand, via one current source each to the reference potential, and in that, in this respect, n signifies the number of networks (N1, N2,...Nn) connected in series.

8. Semi-conductor circuit according to one of Claims 1 to 7, characterized in that it forms a chain with a semi-conductor circuit identical to it, the two outputs (B, $\overline{B}$) belonging to the slave part of one of the networks (N1, N2,...Nn) connected in series (in particular of the last network (Nn)) being used to control one each of the two inputs (1, 2) of the input part (E) of the other semi-conductor circuit.

9. Semi-conductor circuit according to one of Claims 1 to 8, characterized in that the transistors and diodes used in it are each in the form of an npn-type transistor and these npn-type transistors are identical to one another.

# FIG 1

# FIG 2

1

FIG 3

1. Teilerstufe

2. Teilerstufe

# FIG 4

# FIG 5

FIG 6

# FIG 7